# EUROPÄISCHE PATENTSCHRIFT

(11) **EP 2 322 944 B1**
(45) Veröffentlichungstag und Bekanntmachung des Hinweises auf die Patenterteilung: **26.09.2018**
(21) Anmeldenummer: 10014557.2
(22) Anmeldetag: 12.11.2010
(51) Int. Cl.: G01R 29/10

(54) **Hochfrequenz-Messanlage und Verfahren zum Vermessen eines Hochfrequenz- Testobjekts, insbesondere einer Antenne**
High frequency measurement assembly and method for measuring a high frequency test subject, in particular an antenna
Installation de mesure haute fréquence et procédé de mesure d'un objet test haute fréquence, notamment une antenne

(30) Priorität: 17.11.2009 DE 102009053446
(43) Veröffentlichungstag der Anmeldung: 18.05.2011
(73) Patentinhaber: Airbus Defence and Space GmbH, 82024 Taufkirchen (DE)
(72) Erfinder: Herrmann, Jörg,, 85579 Neubiberg (DE)
(74) Vertreter: Frenkel, Matthias Alexander

(56) Entgegenhaltungen:
- WO-A1-86/06550
- DE-A1- 3 309 737
- DE-A1- 19 963 794
- JP-A- 2001 004 680
- US-A- 3 453 633
- US-A1- 2006 220 950
- US-A1- 2009 073 061

## Beschreibung

Die Erfindung betrifft eine Hochfrequenz-Messanlage und ein Verfahren zum Vermessen eines Hochfrequenz-Testobjekts, insbesondere einer Antenne, gemäß Anspruch 1 bzw. 6.

Hochfrequenz (HF)-Testobjekte, insbesondere Antennen wie beispielsweise Satellitenantennen werden hinsichtlich ihrer HF-Eigenschaften in Hochfrequenz - bzw. Antennenmessanlagen untersucht. Von dem Anmelder wurde für hochgenaue Vermessungen von Antennen eine als Compensated Compact Range (CCR) bezeichnete HF-Messanlage geschaffen. Zur Messung stellt die Anlage ein HF-Signal bereit, das eine definierte Ausbreitungsrichtung (Boresight) besitzt. Jedes HF-Testobjekt, insbesondere eine Antenne, muss bezüglich dieses HF-Signals parallel ausgerichtet werden, um möglichst exakte Messungen zu erhalten. Nach dem Einbau in die HF-Messanlage ist daher in der Regel noch eine mechanische Ausrichtung eines HF-Testobjekts erforderlich.

Zur Ausrichtung werden bisher mindestens zwei Theodoliten eingesetzt, wie es beispielsweise in der US2009/0073061A1 beschrieben ist. Die beiden Theodoliten messen am HF-Testobjekt entsprechende Orientierungspunkte und in der Messanlage für die Richtung des HF-Signals einen Würfelspiegel, der die Ausbreitungsrichtung des HF-Signals definiert. Zum Berechnen der Ausrichtung des HF-Testobjekts bezüglich der Ausbreitungsrichtung des HF-Signals müssen zeitaufwendige geometrisch optische Berechnungen durchgeführt werden. Die Spiegelrichtungen des Würfelspiegels der Messanlage müssen hierbei mit den 3D-Koordinaten des HF-Testobjekts kombiniert werden, um entsprechende Korrekturen in den Rotationen des HF-Testobjekts ermitteln zu können. Ein Nachteil dieser Messmethode für die Justage der Ausrichtung des HF-Testobjekts zeigt sich in einer relativ großen Ungenauigkeit der Einzelmessungen und somit in einer relativ ungenauen Ausrichtung des HF-Testobjekts in der Messanlage bezüglich der HF-Messrichtung (Boresight). Ein weiterer Nachteil besteht im hohen Zeit- und Personalaufwand für die Durchführung der Messungen und der Ermittlung von Korrekturwerten für die Justage des HF-Testobjekts.

US 2006/220950 A beschreibt Systeme und Verfahren, die es ermöglichen, nummerisch ein ebenes Feld in einem kompakten Radarbereich mit einem gekrümmten Reflektor und ohne Einsatz von gesonderten Phased-Array-Elementen zu erzeugen.

US 3,453,633 beschreibt Mittel zum Erkennen von Verzerrungen bei großen sphärischen Reflektorantennen und zum Kompensieren der Verzerrungen durch Einstellen des Antennen-Feeds, um eine Strahlausrichtung und - Verstärkung aufrecht zu erhalten.

DE 199 63 794 A1 beschreibt eine Messanordnung zur hochgenauen Ausrichtung/Positionierung und/oder Erfassung von elektromagnetischen Charakteristiken einer Einrichtung zur/mit Abgabe von gerichteten strahlungs- und/oder wellenförmigen Signalen, die eine mit einer Messsonde zur Erfassung der strahlungs- und/oder wellenförmigen Signalen versehene und vor der Abgabeeinrichtung schwebend zu platzierende Einrichtung, insbesondere einen ferngesteuerten Hubschrauber aufweist. Positionen von Laserreflektoren, die an der schwebend zu platzierenden Einrichtung befestigt sind, werden hierbei mit zwei hochgenauen Winkelmessgeräten, nämlich optischen Theodoliten in Azimut und Elevation bestimmt.

Aufgabe der vorliegenden Erfindung ist es daher, eine verbesserte Hochfrequenz-Messanlage und ein verbessertes Verfahren zum Vermessen eines Hochfrequenz-Testobjekts, insbesondere einer Antenne, anzugeben.

Diese Aufgabe wird durch eine Hochfrequenz-Messanlage zum Vermessen eines Hochfrequenz-Testobjekts, insbesondere einer Antenne, mit den

Merkmalen von Anspruch 1 und ein entsprechendes Verfahren mit den Merkmalen von Anspruch 6 gelöst. Weitere Ausgestaltungen der Erfindung sind Gegenstand der abhängigen Ansprüche.

Ein wesentlicher Gedanke der Erfindung besteht darin, mittels eines Lasertrackers ein HF-Testobjekt und einen oder mehrere Reflektoren einer HF-Messanlage hinsichtlich ihrer Ausbreitungsrichtung (Boresight) von HF-Signalen zu vermessen. Abhängig von den Vermessungen kann dann die Ausrichtung des HF-Testobjekts eingestellt werden, insbesondere derart, dass Abweichungen von einer vorgegebenen oder gewünschten Ausrichtung verringert werden. Für eine optimale Vermessung mit dem Lasertracker sind insbesondere Retrotargets an Reflektoren zur Definition der Ausbreitungsrichtung eines HF-Signals einer Messanlage für HF-Testobjekte und Retrotargets am HF-Testobjekt zur Definition der Ausbreitungsrichtung des HF-Signals des HF-Testobjekts wie einer Antenne vorgesehen. Retrotargets sind Reflektoren, die einen einfallenden Laserstrahl insbesondere in seiner Einfallsrichtung zurück reflektieren. Die Erfindung ermöglicht eine relativ genaue Ausrichtung eines HF-Testobjekts bezüglich einer HF-Messrichtung (Boresight) und im Vergleich zum eingangs geschilderten Verfahren eine deutliche Reduzierung des für die Ausrichtung des HF-Testobjekts erforderlichen Aufwands.

Gemäß einer Ausführungsform betrifft die Erfindung nun eine Hochfrequenz -Messanlage zum Vermessen eines Hochfrequenz-Testobjekts, insbesondere einer Antenne, mit
- einem oder mehreren Reflektoren für Hochfrequenzsignale,
- einem Lasertracker,
- Retrotargets für Laserstrahlen des Lasertrackers, die an den Reflektoren angeordnet und zum Anordnen am Hochfrequenz-Testobjekt vorgesehen sind, wobei im Messbetrieb Retrotargets am Hochfrequenz-Testobjekt angeordnet sind,
   und
- einer Messeinheit, die zum Ansteuern des Lasertrackers derart ausgebildet ist, dass das Hochfrequenz-Testobjekt und ein oder mehrere Reflektoren hinsichtlich ihrer Ausbreitung von Hochfrequenzsignalen (Boresight) vermessen werden.

Die Messeinheit kann ferner derart ausgebildet sein, Korrekturwerte für die Ausrichtung des Hochfrequenz-Testobjekts mit einem Best-Fit-Transformations-Programm aus den Lasertracker-Messungen zu berechnen und auszugeben. Die Korrekturwerte können beispielsweise auf einem Monitor angezeigt werden, so dass Servicepersonal das Hochfrequenz-Testobjekt ausrichten kann. Die Korrekturwerte können auch über eine Schnittstelle zur Weiterverarbeitung durch beispielsweise eine Steuerung des Hochfrequenz-Testobjekts ausgegeben werden.

Ferner kann eine Verstelleinrichtung für das Hochfrequenz-Testobjekt vorgesehen und die Messeinheit ferner derart ausgebildet sein, dass sie die Verstelleinrichtung derart steuert, dass Abweichungen der Ausbreitung der Hochfrequenzsignale des Hochfrequenz-Testobjekts von einer vorgegebenen Ausrichtung in Bezug auf die Ausbreitung der Hochfrequenzsignale der Reflektoren verringert werden. Hierdurch kann eine nahezu automatische Justage des Hochfrequenz-Testobjekt in der Messanlage erreicht werden.

Am Hochfrequenz-Testobjekt und an jedem Reflektor können jeweils vier Retrotargets vorgesehen sein, die an den Ecken oder an Rändern des Hochfrequenz-Testobjekts und der Reflektoren angeordnet sind.

Die Retrotargets können derart ausgebildet sein, dass sie einen einfallenden Laserstrahl etwa in seiner Einfallsrichtung zurück reflektieren.

Eine weitere Ausführungsform der Erfindung betrifft ein Verfahren zum Vermessen eines Hochfrequenz-Testobjekts, insbesondere einer Antenne, das den folgenden Schritt aufweist:
- Ansteuern eines Lasertrackers und Vermessen des Hochfrequenz-Testobjekts und eines oder mehrerer Reflektoren hinsichtlich ihrer Ausbreitung von Hochfrequenzsignalen.

Das Verfahren kann ferner durch die folgenden Schritte gekennzeichnet sein:
- Berechnen von Korrekturwerten für die Ausrichtung des Hochfrequenz-Testobjekts mit einem Best-Fit-Transformations-Programm aus den Lasertracker-Messungen und
- Ausgeben der berechneten Korrekturwerte.

Weiterhin kann das Verfahren durch die folgenden Schritte gekennzeichnet sein:
- Steuern einer Verstelleinrichtung für das Hochfrequenz-Testobjekt abhängig von den Messungen derart, dass Abweichungen der Ausbreitung der Hochfrequenzsignale des Hochfrequenz-Testobjekts von einer vorgegebenen Ausrichtung in Bezug auf die Ausbreitung der Hochfrequenzsignale der Reflektoren verringert werden.

Gemäß einer weiteren Ausführungsform betrifft die Erfindung ein Computerprogramm zur Durchführung eines Verfahrens nach der Erfindung und wie vorstehend beschrieben, wenn das Computerprogramm auf einem Computer durchgeführt wird.

Ferner betrifft eine Ausführungsform der Erfindung einen Datenträger, auf dem das Computerprogramm nach der Erfindung und wie vorstehend beschrieben gespeichert ist. Beispielsweise kann der Datenträger ein magnetisches oder optisches Speichermedium oder ein Halbleiterspeicher sein. Unter Datenträger wird auch ein Netzwerkdatenspeicher verstanden, beispielsweise ein Server, der über ein Computernetzwerk wie beispielsweise dem Internet erreichbar ist. Auf diesem Netzwerkspeicher kann das Computerprogramm zum Herunterladen auf einen lokalen Computer vorgehalten werden.

Weitere Vorteile und Anwendungsmöglichkeiten der vorliegenden Erfindung ergeben sich aus der nachfolgenden Beschreibung in Verbindung mit den in den Zeichnungen dargestellten Ausführungsbeispielen.

In der Beschreibung, in den Ansprüchen, in der Zusammenfassung und in den Zeichnungen werden die in der hinten angeführten Liste der Bezugszeichen verwendeten Begriffe und zugeordneten Bezugszeichen verwendet.

Die Zeichnungen zeigen in
Fig. 1 ein schematisches Blockschaltbild eines Ausführungsbeispiels einer CCR-Hochfrequenz-Messanlage zum Vermessen einer auf einem CCR-Drehtisch montierten Antenne gemäß der Erfindung; und
Fig. 2 ein Flussdiagramm eines Ausführungsbeispiels des Verfahrens zum Vermessen einer verstellbaren Antenne gemäß der Erfindung.

In der folgenden Beschreibung können gleiche, funktional gleiche und funktional zusammenhängende Elemente mit den gleichen Bezugszeichen versehen sein. Absolute Werte sind im Folgenden nur beispielhaft angegeben und sind nicht als die Erfindung einschränkend zu verstehen.

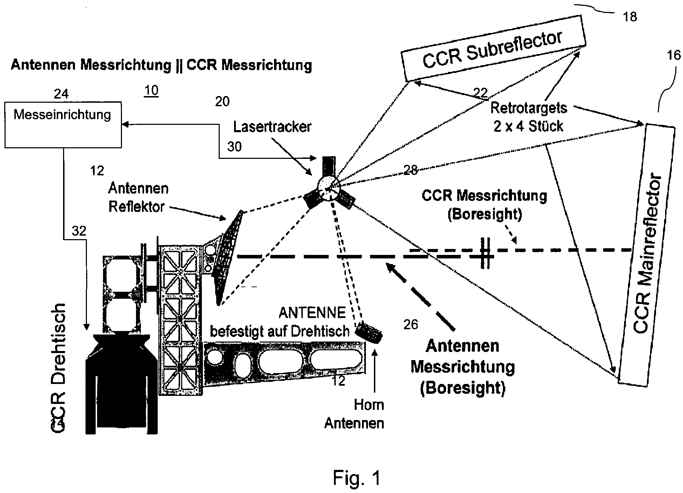

In Fig. 1 ist eine Antennenmessanlage 10 für eine Antenne, z. B. HF-Antenne, gezeigt, die einen Antennenreflektor 12 und Horn-Antennen 12 aufweist, die beide auf einem CCR-Drehtisch 14 befestigt sind. Die Messanlage 10 weist ferner einen CCR-Mainreflektor 16 und einen CCR-Subreflektor 18 auf. Die Anordnung des Mainreflektors 16 und des Subreflektors 18 ist der Fig. 1 zu entnehmen.

Weiterhin weist die Anlage einen Lasertracker 20 auf, der Laserstrahlen zum Vermessen der Reflektoren erzeugt. Der Lasertracker sendet mit den Laserstrahlen Laserimpulse zur Messung der Entfernung von Retrotargets 22 aus, die an den Reflektoren angeordnet sind. Die Retrotargets 22 reflektieren die einfallenden Laserstrahlen mit den Laserimpulsen zurück zum Lasertracker 20, der anhand der Laufzeit der Laserimpulse die Entfernung zwischen Lasertracker 20 und reflektierenden Retrotarget 22 ermitteln kann. Zusätzlich zur Entfernung ermittelt der Lasertracker 20 Winkelwerte der Retrotargets 22 in Bezug auf die Position des Lasertrackers 20. Damit können mit dem Lasertracker 20 die 3D-Positionen von Retrotargets 22 ermittelt werden.

Jeweils vier Retrotargets 22 sind an den Ecken von Mainreflektor 16 und Subreflektor 18 angeordnet. Weiterhin sind Retrotargets 22 am Antennenreflektor 12 angeordnet. Die 8 Retrotargets 22 am Mainreflektor und Subreflektor 16 bzw. 18 definieren mittels ihrer 3D-Koordinaten die Ausbreitungsrichtung des HF-Signals (Boresight) 28 der Messanlage 10. Die Retrotargets am Antennenreflektor 12 definieren die Ausbreitungsrichtung 26 des HF-Signals der zu vermessenden Antenne 12.

Weiterhin ist eine Messeinrichtung 24 zum Steuern des Lasertrackers 20 vorgesehen. Die Messeinrichtung 24 kann ferner zum Steuern des CCR-Drehtisches 14 ausgebildet sein. Die Messeinrichtung 24 steuert zunächst den Lasertracker 20 zum Vermessen der Retrotargets 22 des Mainreflektors 16 und des Subreflektors 18 an. Anschließend steuert sie den Lasertracker 20 zum Vermessen von den Retrotargets am HF-Testobjekt, d.h. am Antennenreflektor 12 an. Die Ausbreitungsrichtungen der HF-Signale von Antenne 12 und Messanlage 10 müssen bei einem HF-Test möglichst parallel zueinander verlaufen, damit möglichst exakte Messergebnisse der zu vermessenden Antenne 12 erhalten werden können. Um dies zu gewährleisten, ermittelt die Messeinrichtung 24 aus den Vermessungen der Retrotargets 22 von Antenne 12 und Messanlage 10 Korrekturwerte, die mittels eines Best-Fit-Transformations-Programms innerhalb von wenigen Sekunden berechnet werden. Die daraus resultierenden Winkelabweichungen werden anschließend mit dem hochpräzisen Drehtisch 14, auf dem die Antenne 12 befestigt ist, minimiert und haben danach nur noch eine maximale Abweichung von etwa 0,003°. Zur entsprechenden Justage der Antenne 12 kann die Messeinrichtung 24 aus den Korrekturwerten Steuersignale 32 zur entsprechenden Ansteuerung des Drehtisches 32 erzeugen.

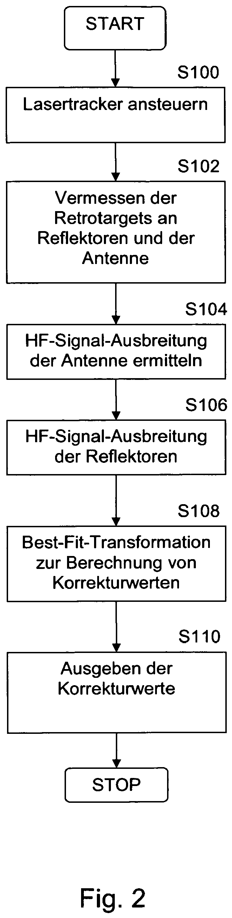

Fig. 2 zeigt das Flussdiagramm eines Verfahrens zum Vermessen einer verstellbaren Antenne, z. B. HF-Antenne, wie es beispielsweise in der Messeinrichtung 24 der Antennenmessanlage 10 von Fig. 1 in Form eines Computerprogramms für einen Mess- und Steuerrechner der Messanlage 10 implementiert sein kann. In einem ersten Schritt S100 wird vom Programm der Lasertracker 20 zum Vermessen von Retrotargets angesteuert. Im darauffolgenden Schritt S102 werden die 3D-Koordinaten der Retrotargets 22 an den Reflektoren 16 und 18 und dem Antennenreflektor 12 ermittelt. Aus den ermittelten 3D-Koordinaten wird die Ausbreitungsrichtung des HF-Signals der zu messenden Antenne 12 im Schritt S104 und der Reflektoren 16 und 18 im Schritt S106 ermittelt. Anschließend werden im Schritt S108 mit einem Best-Fit-Transformations-Programm Korrekturwerte der ermittelten Ausbreitungsrichtungen berechnet und im Schritt S110 ausgegeben. Die berechneten Korrekturwerte können auf einem Monitor für Servicepersonal angezeigt werden oder direkt zum Erzeugen von Steuersignalen für den Drehtisch verwendet werden.

Mit der vorliegenden Erfindung können die Fehler der Ausrichtung eines zu vermessenden HF-Testobjekts wie einer Antenne in einer Hochfrequenz-Messanlage bezüglich der Messrichtung (Boresight) minimiert werden, die beim subjektiven Messen mit Theodoliten immer vorhanden sind. Weiterhin kann eine deutliche Zeitersparnis bei der Vorbereitung der Ausrichtungsmessung eines HF-Testobjekts wie einer Antenne insbesondere während der Ausrichtung selbst aber auch bei der anschließenden Datenauswertung erzielt werden. Versuche haben gezeigt, dass eine Reduzierung der Rüstzeiten von ca. 75% sowie der Ausrichtungsmessung selbst und der anschließenden Datenauswertung um mindestens ca. 30% erreichbar ist.

### BEZUGSZEICHEN

- 10: Antennenmessanlage
- 12: Antennenreflektor und Horn-Antennen der zu vermessenden Antenne
- 14: CCR-Drehtisch
- 16: CCR-Mainreflektor
- 18: CCR-Subreflektor
- 20: Lasertracker
- 22: Retrotargets
- 24: Messeinrichtung
- 26: Ausbreitungsrichtung der HF-Signale in der Antennenmessrichtung (Boresight)
- 28: Ausbreitungsrichtung der HF-Signale in der CCR-Messrichtung (Boresight)
- 30: Mess- und Steuersignale
- 32: Steuersignale für den CCR-Drehtisch 14
- S100-S110: Verfahrensschritte

## Patentansprüche

1. Hochfrequenz-Messanlage (10) zum Vermessen eines Hochfrequenz-Testobjekts, insbesondere einer Antenne (12), mit
- einem oder mehreren Reflektoren (16, 18) für Hochfrequenzsignale, ferner **gekennzeichnet durch**
- einen Lasertracker (20),
- Retrotargets (22) für Laserstrahlen des Lasertrackers, die an den Reflektoren angeordnet und zum Anordnen am Hochfrequenz-Testobjekt vorgesehen sind, wobei einige der Retrotargets (22) im Messbetrieb am Hochfrequenz-Testobjekt angeordnet sind,
und
- eine Messeinheit (24), die zum Ansteuern des Lasertrackers derart ausgebildet ist, dass das Hochfrequenz-Testobjekt und ein oder mehrere Reflektoren hinsichtlich ihrer Ausbreitung von Hochfrequenzsignalen (26, 28) vermessen werden.

2. Anlage nach Anspruch 1,
**dadurch gekennzeichnet, dass**
die Messeinheit (26) ferner derart ausgebildet ist, Korrekturwerte für die Ausrichtung des Hochfrequenz-Testobjekts mit einem Best-Fit-Transformations-Programm aus den Lasertracker-Messungen (30) zu berechnen und auszugeben.

3. Anlage nach Anspruch 1 oder 2,
**dadurch gekennzeichnet, dass**
ferner eine Verstelleinrichtung (14) für das Hochfrequenz-Testobjekt vorgesehen und die Messeinheit (24) ferner derart ausgebildet ist, dass sie die Verstelleinrichtung derart steuert, dass Abweichungen der Ausbreitung der Hochfrequenzsignale des Hochfrequenz-Testobjekts von einer vorgegebenen Ausrichtung in Bezug auf die Ausbreitung der Hochfrequenzsignale der Reflektoren verringert werden.

4. Anlage nach einem der vorhergehenden Ansprüche,
**dadurch gekennzeichnet, dass**
am Hochfrequenz-Testobjekt und jedem Reflektor jeweils vier Retrotargets vorgesehen sind, die an den Ecken oder an Rändern des Hochfrequenz-Testobjekts und der Reflektoren angeordnet sind.

5. Anlage nach einem der vorhergehenden Ansprüche,
**dadurch gekennzeichnet, dass**
die Retrotargets derart ausgebildet sind, dass sie einen einfallenden Laserstrahl etwa in seiner Einfallsrichtung zurück reflektieren.

6. Verfahren zum Vermessen eines Hochfrequenz-Testobjekts, insbesondere einer Antenne (12), mit den folgenden Schritten:
- Ansteuern eines Lasertrackers (S100; 20) und Vermessen des Hochfrequenz-Testobjekts und eines oder mehrerer Reflektoren (16, 18) hinsichtlich ihrer Ausbreitung von Hochfrequenzsignalen (S102, S104, S106) mittels Retrotargets (22) für Laserstrahlen des Lasertrackers, die an den Reflektoren und am Hochfrequenz-Testobjekt angeordnet sind.

7. Verfahren nach Anspruch 6,
ferner **gekennzeichnet durch** die folgenden Schritte:
- Berechnen von Korrekturwerten (S108) für die Ausrichtung des Hochfrequenz-Testobjekts mit einem Best-Fit-Transformations-Programm aus den Lasertracker-Messungen (30) und
- Ausgeben der berechneten Korrekturwerte.

8. Verfahren nach Anspruch 6 oder 7,
ferner **gekennzeichnet durch** die folgenden Schritte:
- Steuern einer Verstelleinrichtung (14) für das Hochfrequenz-Testobjekt abhängig von den Messungen (S120, S122) derart, dass Abweichungen der Ausbreitung der Hochfrequenzsignale des Hochfrequenz-Testobjekts von einer vorgegebenen Ausrichtung in Bezug auf die Ausbreitung der Hochfrequenzsignale der Reflektoren verringert werden.

9. Computerprogramm zur Durchführung eines Verfahrens nach einem der Ansprüche 6 bis 8, wenn das Computerprogramm auf einem Computer durchgeführt wird.

10. Datenträger, auf dem das Computerprogramm nach Anspruch 9 gespeichert ist.

## Claims

1. A high-frequency measurement setup (10) for measuring a high-frequency test object, in particular an antenna (12), comprising
- one or more reflectors (16, 18) for high-frequency signals,
further **characterized by**
- a laser tracker (20),
- retrotargets (22) for laser beams of the laser tracker, the retrotargets being situated on the reflectors and provided for arrangement on the high-frequency test object, wherein in measurement mode some of the retrotargets (22) are situated on the high-frequency test object, and
- a measuring unit (24) that is designed for actuating the laser tracker in such a way that the high-frequency test object and one or more reflectors are measured in terms of their propagation of high-frequency signals (26, 28).

2. The setup according to Claim 1,
**characterized in that**
the measuring unit (26) is also designed for calculating and outputting correction values for the alignment of the high-frequency test object, based on the laser tracker measurements (30), using a best-fit transformation program.

3. The setup according to Claim 1 or 2,
**characterized in that**
an adjustment device (14) for the high-frequency test object is additionally provided, and the measuring unit (24) is designed to control the adjustment device in such a way that deviations in the propagation of the high-frequency signals of the high-frequency test object from a specified alignment in terms of the propagation of the high-frequency signals from the reflectors are reduced.

4. The setup according to one of the preceding claims,
**characterized in that**
four retrotargets each are provided on the high-frequency test object and on each reflector, the retrotargets being situated at the corners or at the edges of the high-frequency test object and of the reflectors.

5. The setup according to one of the preceding claims,
**characterized in that**
the retrotargets are designed to back-reflect an incident laser beam approximately in its direction of incidence.

6. A method for measuring a high-frequency test object, in particular an antenna (12), comprising the following steps:
- actuating a laser tracker (S100; 20) and measuring the high-frequency test object and one or more reflectors (16, 18) in terms of their propagation of high-frequency signals (S102, S104, S106) by means of retrotargets (22), situated on the reflectors and on the high-frequency test object, for laser beams of the laser tracker.

7. The method according to Claim 6,
further **characterized by** the following steps:
- calculating correction values (S108) for the alignment of the high-frequency test object, based on the laser tracker measurements (30), using a best-fit transformation program, and
- outputting the calculated correction values.

8. The method according to Claim 6 or 7,
further **characterized by** the following steps:
- controlling an adjustment device (14) for the high-frequency test object as a function of the measurements (S120, S122) in such a way that deviations in the propagation of the high-frequency signals of the high-frequency test object from a specified alignment in terms of the propagation of the high-frequency signals from the reflectors are reduced.

9. A computer program for carrying out a method according to one of Claims 6 to 8 when the computer program is executed on a computer.

10. A data carrier on which the computer program according to Claim 9 is stored.

## Revendications

1. Dispositif de mesure à haute fréquence (10), destiné à mesurer un objet de test à haute fréquence, en particulier une antenne (12), comprenant
- un ou plusieurs réflecteurs (16, 18) destinés à des signaux à haute fréquence,
**caractérisé en outre par**
- un suiveur à laser (20),
- des rétro-cibles (22), destinés à des faisceaux laser du suiveur à laser, qui sont disposés au niveau des réflecteurs et qui sont prévus pour être disposés au niveau de l'objet de test à haute fréquence, certains des rétro-cibles (22) étant disposés en mode de mesure au niveau de l'objet de test à haute fréquence, et
- une unité de mesure (24) conçue pour commander le suiveur à laser de telle sorte que l'objet de test à haute fréquence et un ou plusieurs réflecteurs soient mesurés en termes de propagation de signaux à haute fréquence (26, 28).

2. Système selon la revendication 1,
**caractérisé en ce que**
l'unité de mesure (26) est également conçue pour calculer et délivrer des valeurs de correction destinées à l'orientation de l'objet de test à haute fréquence à l'aide d'un programme de transformation de meilleur ajustement sur la base des mesures (30) du suiveur à laser.

3. Système selon la revendication 1 ou 2,
**caractérisé en ce que**
il est en outre prévu un dispositif de réglage (14) destiné à l'objet de test à haute fréquence, et l'unité de mesure (24) est conçue pour commander le dispositif de réglage de façon à réduire les écarts de la propagation des signaux à haute fréquence de l'objet de test à haute fréquence par rapport à la propagation spécifiée en termes de propagation des signaux à haute fréquence des réflecteurs.

4. Système selon l'une des revendications précédentes,
**caractérisé en ce que**
quatre rétro-cibles sont prévus au niveau de l'objet de test à haute fréquence et de chaque réflecteur qui sont situés au niveau des angles ou des bords de l'objet de test à haute fréquence et des réflecteurs.

5. Système selon l'une des revendications précédentes,
**caractérisé en ce que**
les rétro-cibles sont conçus pour réfléchir en retour un faisceau laser incident approximativement dans sa direction d'incidence.

6. Procédé de mesure d'un objet de test à haute fréquence, notamment une antenne (12), comprenant les étapes suivantes :
- commander un suiveur à laser (S100 ; 20) et mesurer l'objet de test à haute fréquence et un ou plusieurs réflecteurs (16, 18) en termes de propagation de signaux à haute fréquence (S102, S104, S106) au moyen de rétro-cibles (22) situés au niveau des réflecteurs et de l'objet de test à haute fréquence et destinés à des faisceaux laser du suiveur à laser.

7. Procédé selon la revendication 6,
**caractérisé en outre par** les étapes suivantes :
- calculer des valeurs de correction (S108) destinées à l'orientation de l'objet de test à haute fréquence à l'aide d'un programme de transformation de meilleur ajustement sur la base des mesures de (30) suiveur à laser, et
- délivrer en sortie des valeurs de correction calculées.

8. Procédé selon la revendication 6 ou 7,
**caractérisé en outre par** les étapes suivantes :
- commander un dispositif de réglage (14) destiné à l'objet de test à haute fréquence en fonction des mesures (S120, S122) de façon à réduire les écarts de la propagation des signaux à haute fréquence de l'objet de test à haute fréquence par rapport à une orientation spécifiée en termes de propagation des signaux à haute fréquence des réflecteurs.

9. Programme informatique destiné à la mise en oeuvre d'un procédé selon l'une des revendications 6 à 8 lorsque le programme informatique est exécuté sur un ordinateur.

10. Support de données sur lequel est stocké le programme informatique selon la revendication 9.
